# EUROPÄISCHE PATENTSCHRIFT

(11) **EP 2 729 965 B1**
(45) Veröffentlichungstag und Bekanntmachung des Hinweises auf die Patenterteilung: **05.08.2020**
(21) Anmeldenummer: 12731389.8
(22) Anmeldetag: 26.06.2012
(51) Int. Cl.: H01L 23/488, H01L 23/367, H01L 21/60, H01L 23/498, H01L 23/373

(54) **VERFAHREN ZUM HERSTELLEN EINES HALBLEITERBAUELEMENTS MIT STRUKTURIERTER SINTERVERBINDUNGSSCHICHT UND HALBLEITERBAUELEMENT MIT STRUKTURIERTER SINTERVERBINDUNGSSCHICHT**
METHOD FOR FABRICATING A SEMICONDUCTOR COMPONENT WITH A STRUCTURED SINTERED CONNECTION LAYER AND SEMICONDUCTOR COMPONENT WITH A STRUCTURED SINTERED CONNECTION LAYER
PROCÉDÉ POUR FABRIQUER UN COMPOSANT À SEMI-CONDUCTEUR AVEC UNE COUCHE DE CONNEXION FRITTÉE STRUCTURÉE ET COMPOSANT À SEMI-CONDUCTEUR AVEC UNE COUCHE DE CONNEXION FRITTÉE STRUCTURÉE

(30) Priorität: 04.07.2011 DE 102011078582
(43) Veröffentlichungstag der Anmeldung: 14.05.2014
(73) Patentinhaber: Robert Bosch GmbH, 70442 Stuttgart (DE)
(72) Erfinder: GUYENOT, Michael, 71638 Ludwigsburg (DE); GUENTHER, Michael, 70469 Stuttgart (DE); HERBOTH, Thomas, 71636 Ludwigsburg (DE)
(86) Internationale Anmeldenummer: PCT/EP2012/062304
(87) Internationale Veröffentlichungsnummer: WO 2013/004543

(56) Entgegenhaltungen:
- EP-A1- 1 450 402
- EP-A2- 1 995 774
- EP-A2- 2 075 835
- DE-A1-102006 009 021
- JP-A- 2008 311 371
- BAI G: "Low-Temperature Sintering of Nanoscale Silver Paste for Semiconductor Device Interconnection", Dissertation submitted to the faculty of the Virginia Polytechnic Institute and State University in partial fulfillment of the requirement for the degree of Doctor of Philosophy in Materials Science and Engineering , October 2005 (2005-10), pages 1-195, XP009166994, Retrieved from the Internet: URL:http://scholar.lib.vt.edu/theses/avail able/etd-10312005-163634/
- "Kapitel 2: NTV-Kontaktschicht" In: RUDZKI J: "Aufbaukonzepte für die Leistungselektronik mit der Niedertemperatur-Verbindungstechnik (Fortschritt-Berichte VDI, Reihe 21, Nr. 376)", 2006, VDI Verlag GmbH, XP55130825, ISBN: 978-3-18-337621-6 pages 4-26,
- "Kapitel 3: Uniaxiales Pressverfahren" In: RUDZKI J: "Aufbaukonzepte für die Leistungselektronik mit der Niedertemperatur-Verbindungstechnik (Fortschritt-Berichte VDI, Reihe 21, Nr. 376)", 2006, VDI Verlag GmbH, XP55130828, ISBN: 978-3-18-337621-6 pages 27-57,
- "Kapitel 4: Kleinflächige NTV-Kontakte" In: RUDZKI J: "Aufbaukonzepte für die Leistungselektronik mit der Niedertemperatur-Verbindungstechnik (Fortschritt-Berichte VDI, Reihe 21, Nr. 376)", 2006, VDI Verlag GmbH, XP55130830, ISBN: 978-3-18-337621-6 pages 58-76,

## Beschreibung

Die Erfindung betrifft ein Verfahren zum Herstellen von strukturierten Sinterschichten und ein Halbleiterbauelement, insbesondere ein Leistungselektronik-Bauelement, mit strukturierter Sinterschicht.

### Stand der Technik

Leistungselektronische Bauelemente wie Leistungsdioden, (vertikale) Leistungstransistoren oder andere Bauteile müssen auf Substraten montiert werden. Aufgrund der hohen Ströme durch derartige Bauelemente ist es wichtig, eine gute elektrische und thermische Ankopplung der Bauelemente mit dem Substrat zu gewährleisten.

Zur mechanischen Verbindung zwischen Halbleitern und metallischen Schichten, beispielsweise Kupferschichten können Sinterverbindungen auf Silberbasis ("Silbersintern") eingesetzt werden, beispielsweise die Niedertemperatur-Verbindungstechnik der Leistungselektronik (Fortschritt-Berichte des VDI, Reihe 21, Nr. 365, VDI-Verlag) und verwandte Verfahren. Beim Silbersintern wird eine Paste mit Mikropartikeln oder Nanopartikeln auf Siberbasis unter erhöhter Temperatur und erhöhtem Druck zusammengepresst, wobei sich die einzelnen Partikel zu einer mechanisch stabilen Sinterschicht zusammenlagern und eine stabile mechanische Verbindung zwischen zwei an der Sinterschicht angrenzenden Komponenten vermitteln.

Aufgrund der unterschiedlichen Wärmeausdehnungskoeffizienten von Halbleitern und metallischen Schichten kann es dabei zu mechanischen Verspannungen in der Sinterschicht kommen, die die Stabilität und Zuverlässigkeit der Sinterschicht beeinträchtigen können.

In der Druckschrift EP 2 075 835 A2 sind Verfahren zum Ausbilden von Sinterschichten zwischen einem Halbleiterchip und einem Substrat offenbart, mit denen die mechanische Stabilität durch Beabstandung der Sinterschicht von den Kanten des Halbleiterchips sowie Ausbildung von Zwischenräumen zwischen einzelnen Sinterabschnitten verbessert werden kann.

Bai G: "Low-Temperature Sintering of Nanoscale Silver Paste for Semiconductor Device Interconnection", Dissertation submitted to the faculty of the Virginia Polytechnic Institute and State University in partial fulfillment of the requirement for the degree of Doctor of Philosophy in Materials Science and Engineering, Oktober 2005, Seiten 1-195, gefunden im Internet:URL:http:// scholar.lib.vt.edu/theses/available/etd-10312005-163634/ offenbart die Oberbegriffe der unabhängigen Ansprüche 1 und 6.

### Offenbarung der Erfindung

Die vorliegende Erfindung betrifft ein Verfahren zum Herstellen eines Halbleiterbauelements gemäß Anspruch 1 sowie ein Halbleiterbauelement, insbesondere ein Leistungselektronik-Halbleiterbauelement, gemäß Anspruch 6.

### Vorteile der Erfindung

Eine grundlegende Idee der Erfindung ist es, eine Sinterschichtverbindung zwischen einem Substrat und einem Chip herzustellen, die sowohl eine gute elektrische und thermische Anbindung zwischen dem Substrat und dem Chip herstellt als auch mechanische Spannungen im Chip vermindert. Dies wird durch eine Sinterschicht gelöst, die aus einer Vielzahl von Sinterelementen besteht, die in strukturierter Weise zwischen Substrat und Chip aus einer Kontaktfläche platziert werden. Durch eine höhere Flächenbelegungsdichte der Sinterelemente in der Mitte der Kontaktfläche kann eine gute thermische und elektrische Leitfähigkeit dort gewährleistet werden, wo im Betrieb des Chips typischerweise eine hohe Temperaturentwicklung auftritt. Am Rand der Kontaktfläche ist die Flächenbelegungsdichte der Sinterelemente geringer als in der Mitte, so dass dort der Kompressionsdruck beim Sintern auf jedes der Sinterelemente effektiv höher als in der Mitte ist, wodurch sich die Zuverlässigkeit der Sinterverbindung im Randbereich erhöht.

Zu jedem der Sinterelemente wird ein Durchgangskanal entlang der Hauptoberfläche des Substrats zwischen Chip und Substrat gebildet, so dass eine Be- und Entgasung während des Sintervorgangs für jedes der Sinterelemente gewährleistet ist. Insbesondere die für ein hinreichendes Versintern erforderliche Sauerstoffzufuhr kann für jedes der Sinterelemente über die Durchgangskanäle während des Sinterns sichergestellt werden. Gleichzeitig können aus den Sinterelementen austretende Gase beim Versintern über die Durchgangskanäle abgeleitet werden, so dass vorteilhafterweise eine gleichmäßige und vorhersagbare Ausbildung der Sinterschicht in allen Bereichen der Kontaktfläche möglich ist.

Vorteilhafterweise können insbesondere im Randbereich viele Sinterelemente ausgebildet werden, so dass auch bei einem Ausfall einzelner Sinterverbindungen während oder nach dem Sintern, das heißt, bei mangelnder thermischer oder elektrischer Leitfähigkeit über einzelne Sinterelemente die gesamte thermische bzw. elektrische Leitfähigkeit der Sinterschicht nicht beeinträchtigt wird, da andere Sinterelemente im Randbereich die Funktion der ausgefallenen Sinterelemente übernehmen können.

Es kann vorteilhaft sein, die Flächenbelegungsdichte der Sinterelemente auf dem Substrat in einem Bereich der Kontaktfläche zwischen dem Mittelbereich und dem Randbereich graduell von der Flächenbelegungsdichte in dem Randbereich hin zu der Flächenbelegungsdichte in dem Mittelbereich der Kontaktfläche zu erhöhen.

Vorteilhafterweise kann der Rand der Kontaktfläche in lateraler Richtung entlang der Hauptoberfläche des Substrats von den Kanten des Chips um eine vorbestimmte Länge beabstandet sein. Dies kann vorteilhafterweise eine Entlastung der bruchgefährdeten Chipkante von mechanischen Spannungen gewährleisten.

Weiterhin kann es vorteilhaft sein, die laterale Ausdehnung der Sinterelemente im Mittelbereich der Kontaktfläche im Vergleich zur lateralen Ausdehnung der Sinterelemente im Randbereich der Kontaktfläche größer zu wählen. Zum Einen wird dadurch in dem mechanisch weniger stark belasteten Mittelbereich der Kontaktfläche eine hohe Flächebelegungsdichte und damit eine verbesserte thermische und elektrische Kontaktierung der Sinterschicht mit dem Chip erreicht. Zum Anderen erhöht sich durch die geringere Flächenbelegungsdichte im Randbereich der effektive Sinterdruck auf jedes der kleineren Sinterelemente im Randbereich, wodurch die Zuverlässigkeit des Sinterprozesses und die Festigkeit der Sinterverbindung im mechanisch stark belasteten Randbereich der Kontaktfläche erhöht wird.

Bevorzugte Weiterbildungen sind Gegenstand der jeweiligen Unteransprüche.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung, die durch die unabhängigen Ansprüche definiert wird.

### Kurze Beschreibung der Zeichnungen

Weitere Merkmale und Vorteile von Ausführungsformen der Erfindung ergeben sich aus der nachfolgenden Beschreibung mit Bezug auf die beigefügten Zeichnungen.

Es zeigen:
- Fig. 1a bis 1c: schematische Darstellungen der Stufen eines Verfahrens zum Herstellen einer strukturierten Sinterschicht auf einem Substrat gemäß einer Ausführungsform der Erfindung;
- Fig. 2: eine schematische Darstellung eines Bauelements mit strukturierten Sinterschichten gemäß einer weiteren Ausführungsform der Erfindung;
- Fig. 3: eine schematische Darstellung eines Bauelements mit strukturierten Sinterschichten gemäß einer weiteren Ausführungsform der Erfindung;
- Fig. 4: eine schematische Darstellung der Oberflächenstrukturierung eines Bauelements mit einer Sinterschicht gemäß einem nicht zum beanspruchten Gegenstand gehörenden Beispiel; und
- Fig. 5: eine schematische Darstellung der Oberflächenstrukturierung eines Bauelements mit einer Sinterschicht gemäß einer Ausführungsform der Erfindung.

In den Figuren der Zeichnung sind gleiche und funktionsgleiche Elemente, Merkmale und Komponenten - sofern nichts Anderes ausgeführt ist - jeweils mit denselben Bezugszeichen versehen. Es versteht sich, dass Komponenten und Elemente in den Zeichnungen aus Gründen der Übersichtlichkeit und Verständlichkeit nicht notwendigerweise maßstabsgetreu zueinander wiedergegeben sind.

### Ausführliche Beschreibung der Erfindung

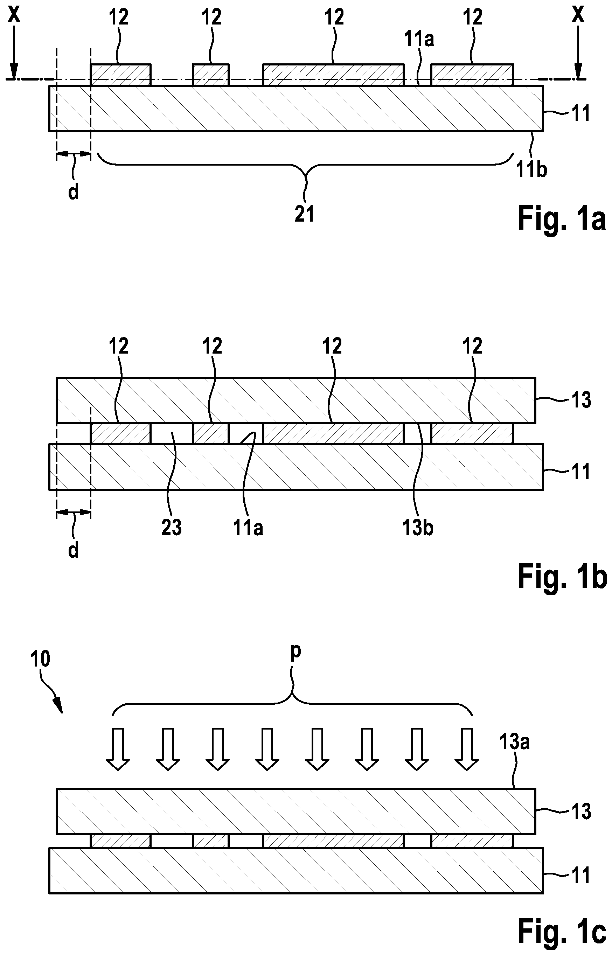

In den Fig. 1a bis 1c werden Stufen eines Verfahren zum Herstellen strukturierter Sinterschichten 12 auf einem Substrat 11 gezeigt. Fig. 1a zeigt eine schematische Darstellung eines Substrats 11 mit einer ersten Hauptoberfläche 11a und einer der ersten Hauptoberfläche 11a gegenüber liegenden Hauptoberfläche 11b. Das Substrat 11 kann beispielsweise ein Metallsubstrat, insbesondere ein Kupfersubstrat, oder ein mit Metall beschichtetes Substrat sein. Eine Edelmetalloberfläche, beispielsweise durch eine Nickel-Gold-Metallisierung auf einem Kupfersubstrat, kann eine gute Adhäsion der Sinterschicht an das Substrat sicherstellen. Auf der Hauptoberfläche 11a werden Sinterelemente für die Ausbildung einer Sinterschicht 12 aufgebracht. Die Sinterelemente werden strukturiert aufgebracht, das heißt, es werden Bereiche auf der Hauptoberfläche 11a des Substrats 11 mit einem die Sinterschicht 12 ausbildenden Material, beispielsweise einer Sinterpaste, belegt, während andere Bereiche nicht von dem Material belegt werden. Beispielhaft sind dazu in Fig. 1a vier Bereiche der Sinterschicht 12 gezeigt, die durch freigelassene Bereiche unterbrochen werden.

Die Sinterschicht 12 kann aus einer Vielzahl von Sinterelementen bestehen, welche innerhalb einer Kontaktfläche 21 auf der Hauptoberfläche 11a des Substrats 11 aufgebracht werden. Die Sinterelemente werden dabei in strukturierter Form aufgebracht, beispielsweise über ein Siebdruckverfahren, ein Schablonendruckverfahren, ein Maskendruckverfahren, ein Tintendruckverfahren, ein Sprühverfahren oder ähnliche Strukturierungstechniken. Die Sinterelemente werden dabei aus einem Ausgangsmaterial für die Sinterschicht 12 hergestellt, beispielsweise eine Sinterpaste mit Silbermikropartikeln. Die Sinterpaste kann neben Lösungsmitteln einen oder mehrere wärmebehandlungsflüchtige Bestandteile, insbesondere einen Stabilisator, aufweisen. Bei dem Bestandteil kann es sich um ein Wachs, insbesondere um ein Mahlwachs, vorzugsweise Stearinsäure, handeln. Der Bestandteil wird bei der Wärmebehandlung, die den Sintervorgang in Gang setzt, zumindest teilweise ausgetrieben, wodurch sich die Silberpartikel zusammenlagern können.

Die Sinterschicht 12 kann mit einer Sinterschichtdicke, die von der Druckschichtdicke zu unterscheiden ist, zwischen 5 µm und 100 µm, insbesondere zwischen 15 µm und 100 µm, insbesondere mit etwa 25 µm, hergestellt werden. Die Sinterelemente der Sinterschicht 12 können vor dem eigentlichen Sintervorgang über ein Trocknungsverfahren getrocknet werden, so dass das Material, welches von den Sinterelementen umfasst wird, weitgehend von Lösungsmittel befreit wird, wodurch eine gewisse Druckfestigkeit erreicht und die spätere Ausgasung des Lösungsmittels während des eigentlichen Sinterprozesses vermieden oder reduziert werden kann.

Fig. 1b zeigt eine schematische Darstellung einer zweiten Stufe des Verfahrens. Ein Halbleiterchip 13 wird auf die Sinterelemente mit einer Oberfläche 13b aufgesetzt. Der Chip 13 kann zum Beispiel ein Leistungstransistor, eine Leistungsdiode oder ein anderes Leistungsbauelement umfassen. Vorzugsweise kann der Chip 13 einen MOSFET, einen IGBT, einen JFET, einen BJT, einen schaltbaren Thyristor oder ein ähnliches Bauelement umfassen.

Der Chip 13 kann dabei eine Oberfläche 13b umfassen, deren laterale Ausdehnung größer ist als die laterale Ausdehnung der Kontaktfläche 21 ist. Insbesondere kann die Kontaktfläche 21 um einen vorbestimmten Abstand d von der Seitenkante des Chips 13 beabstandet sein. Der Abstand d kann dabei um die Kontaktfläche 21 umlaufend sein, und einen sogenannten "Underprint" herstellen, das heißt, eine nicht vollständige Verbindung der gesamten Oberfläche 13b des Chips 13 über die Sinterschicht 12. Dies kann vorteilhafterweise eine Entlastung der bruchgefährdeten Chipkanten gewährleisten. Zwischen den Sinterelementen können Durchgangskanäle 23 ausgebildet werden. Die Durchgangskanäle 23 können zwischen dem Substrat 11 und dem Chip 13 lateral zu der Hauptoberfläche 11a des Substrats 11 verlaufen. Jedes der Sinterelemente steht über einen Durchgangskanal 23 mit dem Rand der Kontaktfläche in Verbindung. Die Durchgangskanäle 23 dienen dazu, Prozessgase zu und von den Sinterelementen während des Sintervorgangs zu führen. Beispielsweise kann über die Durchgangskanäle Sauerstoff zu den Sinterelementen hingeführt werden, so dass ein hinreichendes Versintern der Sinterpaste erfolgen kann. Es kann auch vorgesehen sein, dass über die Durchgangskanäle 23 Gase, welche beim Sintern der Sinterelemente aus dem Sintermaterial austreten, aus dem Halbleiterbauelement abgeführt werden. Ohne derartige Durchgangskanäle 23 könnten diese Gase über zufällige Wege aus dem Halbleiterbauelement austreten und somit nicht reproduzierbare Entgasungskanäle bilden, welche die Eigenschaften der Sinterschicht 12 negativ beeinflussen können.

In einer dritten in Fig. 1c gezeigten Stufe des Verfahrens wird die Sinterschicht 12 durch Erhitzen, beispielsweise auf eine vorbestimmte Sintertemperatur zwischen 200°C und 400°C gemäß einer Temperaturprofil-Vorgabe, und durch Kompression des Chips 13 und des Substrats 11, beispielsweise gemäß einer Druckprofil-Vorgabe, ausgebildet. Dazu kann ein Druck p von weniger als 30 MPa, insbesondere weniger als 10 MPa, senkrecht zur Hauptoberfläche 11a des Substrats auf den Chip 13 bzw. das Substrat 11 ausgeübt werden, wie schematisch durch die Pfeile in Fig. 1c dargestellt. Durch die Kompression können die Sinterelemente in der Dicke reduziert werden. Dadurch wird ein Halbleiterbauelement 10 mit einem Substrat 11, einem Halbleiterchip 13 und einer das Substrat 11 und den Chip 13 verbindenden Sinterschicht 12 hergestellt.

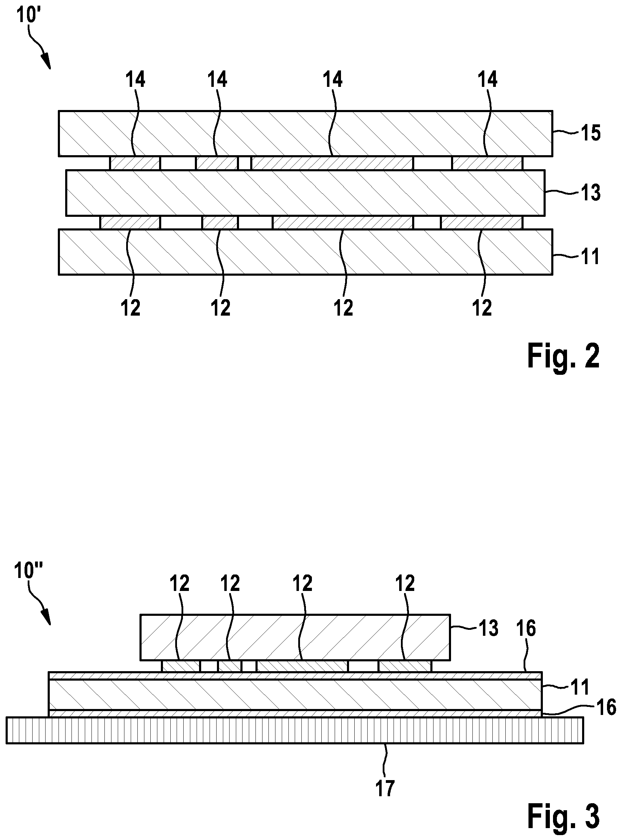

Fig. 2 zeigt eine schematische Darstellung eines Bauelements 10' mit strukturierten Sinterschichten 12, 14. Das Bauelement 10' unterscheidet sich von dem Bauelement 10 in Fig. 1c dahingehend, dass der Chip 13 auf beiden Hauptoberflächen mit Sinterschichten 12 bzw. 14 mit jeweils einem Substrat 11 bzw. 15 verbunden ist. Das Substrat 15 kann dabei dem Substrat 11 ähnlich sein.

Fig. 3 zeigt eine schematische Darstellung eines Bauelements 10" mit einer strukturierten Sinterschicht 12. Das Bauelement 10" unterscheidet sich von dem Bauelement 10 in Fig. 1c dahingehend, dass der Chip 13 ein vertikaler Leistungs-MOSFET oder -IGBT ist, welcher über eine Sinterschicht 12 mit einem Substrat 11 verbunden ist. Das Substrat 11 kann dabei ein DBC-Substrat ("directly bonded copper") sein, welches beispielsweise Keramik mit niedrigem Wärmeausdehnungskoeffizienten umfasst, und welches an seinen beiden Hauptoberflächen mit einer Kupferschicht 16 versehen ist. Es kann auch möglich sein, dass das Substrat ein IMS (Insulated Metal Substrate)-Substrat, PCB (Printed Circuit Board)-Substrat, AMB (Active Metal Brazing)-Substrat oder ein keramisches Ein- oder Mehrlagensubstrat umfasst. Das Substrat 11 kann dabei auf einer vollständig aus Metall, beispielsweise Kupfer, gefertigten Wärmesenke 17 angeordnet sein, über welche eine Wärmeabfuhr der in dem Leistungs-MOSFET erzeugten Wärme erfolgen kann.

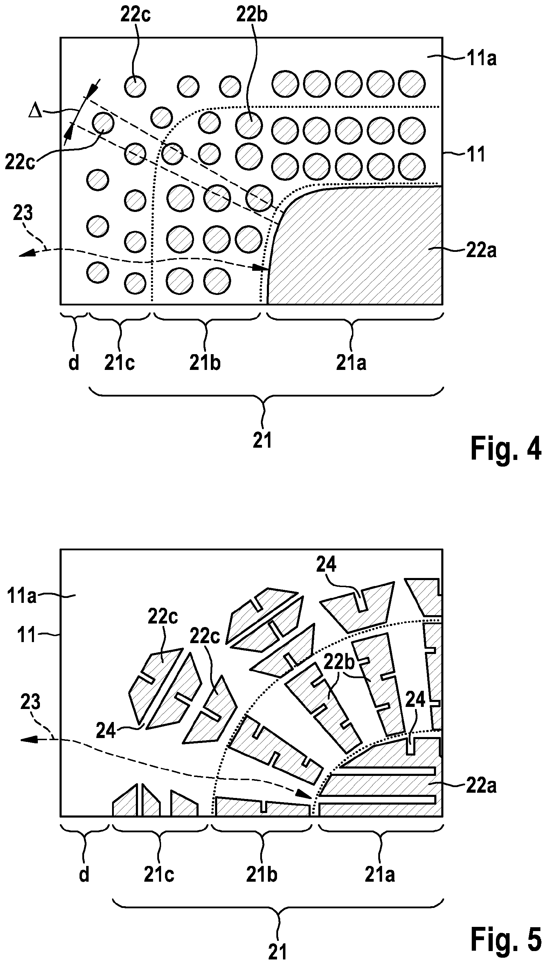

Es werden in der Fig. 4 ein Beispiel, das nicht zum beanspruchten Gegenstand gehört und in der Fig. 5 eine beispielhafte Ausführungsform gezeigt, die die Strukturierung der Sinterschicht 12 durch verschiedene Formen und Verteilungen der Sinterelemente 22a, 22b, 22c betreffen.

Die in Fig. 4 und 5 gezeigten Darstellungen sind Schnittansichten entlang der in Fig. 1a gezeigten Schnittlinie x-x.

In den Fig. 4 und 5 ist jeweils ein Substrat 11 mit aus der Zeichenebene heraus weisender Hauptoberfläche 11a gezeigt, auf der Hauptoberfläche 11a ist eine Kontaktfläche 21 ausgebildet, innerhalb derer jeweils eine Vielzahl von Sinterelementen 22a, 22b, 22c ausgestaltet ist. Die Ränder der Kontaktfläche, das heißt, die im Bezug auf die Mitte der Kontaktfläche äußersten Sinterelemente 22c, sind vorteilhafterweise jeweils um mindestens einen vorbestimmten Abstand d von dem Rand des Substrats 11 beabstandet.

Die Darstellungen in Fig. 4 und 5 zeigen jeweils ein Viertel des Substrats 11, wobei die Ecke rechts unten jeweils in der Mitte des Substrats 11 liegt. Mit anderen Worten kann das Substrat 11 in vier Quadranten eingeteilt werden, von denen jeder der Quadranten mit einer der Anordnung der Sinterelemente 22a, 22b, 22c entsprechenden, gespiegelten Anordnung versehen sein kann. Auf diese Weise ergibt sich jeweils ein Substrat 11 mit einer Kontaktfläche 21, welche einen in der Mitte des Substrats 11 liegenden Mittelbereich 21a, einen am Rand der Kontaktfläche 21 liegenden Randbereich 21c und einen zwischen Mittelbereich 21a und Randbereich 21c liegenden Zwischenbereich 21b aufweist. Die Grenzen der Bereiche 21a, 21b und 21c der Kontaktfläche 21 sind jeweils durch entsprechende Grenzlinien in den Fig. 4 und 5 angedeutet.

In dem in Fig. 4 gezeigten, nicht zum beanspruchten Gegenstand gehörenden Beispiel ist im Mittelbereich 21a ein großflächiges Sinterelement 22a angeordnet. Der Mittelbereich 21a kann beispielsweise mindestens 10%, insbesondere mehr als 20% der Kontaktfläche belegen. Das Sinterelement 22a stellt sicher, dass im Mittelbereich eine gute thermische und/oder elektrische Kontaktierung zwischen dem Substrat 11 und dem Chip 13 hergestellt wird. Die Flächenbelegungsdichte des Mittelbereichs 21a, das heißt, der Anteil pro Flächeneinheit der Hauptoberfläche 11a, der mit Sinterelementen bedeckt ist, ist damit sehr groß.

In einem Randbereich 21c hingegen sind eine Vielzahl von Sinterelementen 22c angeordnet, die beispielsweise kreisförmig sein können. Die laterale Ausdehnung der Sinterelemente 22c, das heißt beispielsweise ihr Durchmesser ist wesentlich kleiner als die laterale Ausdehnung des Sinterelements 22a. Andererseits ist die Anzahl der Sinterelemente 22c wesentlich höher als die Anzahl der Sinterelemente 22a im Mittelbereich 21a. Die Flächenbelegungsdichte im Randbereich 21c ist kleiner als die Flächenbelegungsdichte im Mittelbereich 21a. Dadurch kann zum Einen erreicht werden, dass der beim Sintervorgang ausgeübte Druck auf die einzelnen Sinterelemente 22c im Randbereich 21c höher ist als der ausgeübte Druck auf die Sinterelemente 22a im Mittelbereich. Dies führt zu einer höheren mechanischen Stabilität der Sinterverbindung im Randbereich 21c gegenüber dem Mittelbereich 21. Zum Anderen stellen die Sinterelemente 22c untereinander Ersatzsinterverbindungen dar. Mit anderen Worten führt ein Ausfall der Sinterverbindung eines einzelnen Sinterelements 22c im Randbereich 21c nicht zur elektrischen, thermischen oder mechanischen Überlastung des Chips 13, da die Vielzahl der übrigen funktionsfähigen Sinterelemente 22c diesen Ausfall kompensieren kann. Damit kann die Funktionsfähigkeit der gesamten Sinterschicht 12 sichergestellt werden.

Es kann vorgesehen sein, in einem Zwischenbereich 21b, welcher zwischen dem Randbereich 21c und dem Mittelbereich 21a liegt, Sinterelemente 22b vorzusehen, die eine laterale Ausdehnung aufweisen, welche zwischen derjenigen der Sinterelemente 22a im Mittelbereich 21a und derjenigen der Sinterelemente 22c im Randbereich 21c liegt. Zudem kann die Flächenbelegungsdichte der Sinterelemente 22b im Zwischenbereich 21b zwischen derjenigen im Mittelbereich 21a und derjenigen im Randbereich 21c liegen.

Die gesamte Anzahl der Sinterelemente 22a, 22b, 22c kann beispielsweise zwischen 6 und 300 liegen, insbesondere zwischen 12 und 240. Diese Anzahl kann allerdings in Abhängigkeit von der lateralen Ausdehnung des Chips 13 variiert werden. Die Sinterelemente 22c im Randbereich können beispielsweise in einem vom Zentrum des Substrats 11 aus gemessenen Winkelbereich Δ liegen. Jedes der im Randbereich 21c Sinterelemente 22c kann beispielsweise einen Winkelbereich Δ von weniger als 75°, insbesondere weniger als 30° einnehmen.

Zu jedem der Sinterelemente 22a, 22b, 22c führt ein Durchgangskanal 23 zum Rand der Kontaktfläche 21, über welchen Prozessgase während des Sintervorgangs der Sinterelemente 22a, 22b, 22c ab- bzw. zugeführt werden können. Beispielhaft ist in Fig. 4 einer der Durchgangskanäle zu dem Sinterelement 22a im Mittelbereich 21a als gestrichelter Doppelpfeil gezeigt.

In dem in Fig. 5 gezeigten Ausführungsbeispiel ist im Mittelbereich 21a ein großflächiges Sinterelement 22a angeordnet. Die Sinterelemente 22b und 22c im Zwischenbereich 21b bzw. Randbereich 21c können trapezoide, polygone oder sonstige geeignete Formen aufweisen. Die Illustration in Fig. 5 ist dabei nur beispielhaft zu verstehen - jede andere Form und Größe der Sinterelemente 22b und 22c kann ebenso geeignet sein. Die Sinterelemente 22a, 22b und 22c weisen zusätzlich Einkerbungen 24 auf, welche einen besseren Zugang zu Innenbereichen der Sinterelemente 22a, 22b und 22c ermöglichen. Über diese Einkerbungen bzw. Zugangskanäle 24 können Prozessgase leichter zur Mitte der Sinterelemente 22a, 22b und 22c zugeführt bzw. von selbigen abgeführt werden. Dies ermöglicht einen gleichmäßigeren und stabileren Sinterprozess. Wiederum führt zu jedem der Sinterelemente 22a, 22b und 22c mindestens ein Durchgangskanal 23, von denen beispielhaft einer zu dem Sinterelement 22a im Mittelbereich 21a als gestrichelter Doppelpfeil gezeigt ist.

Zusätzlich zu der Sinterschicht 12 können die Halbleiterbauelemente 10, 10' und 10" jeweils mit weiteren Materialien zur Verbesserung der thermischen und/oder elektrischen Anbindung versehen werden, beispielsweise mit Underfillmaterial, Leitkleber, Lot, Wärmeleitpasten oder ähnlichen Materialien.

## Patentansprüche

1. Verfahren zum Herstellen eines Halbleiterbauelements (10), mit den Schritten:
strukturiertes Aufbringen einer Vielzahl von Sinterelementen (22a, 22b, 22c) aus einem eine Sinterschicht (12) ausbildenden Ausgangsmaterial auf einer Kontaktfläche (21) einer Hauptoberfläche (11a) eines Substrats (11);
Anordnen eines mit dem Substrat (11) zu verbindenden Halbleiterchips (13) auf den Sinterelementen (22a, 22b, 22c); und
Erhitzen und Komprimieren der Sinterelemente (22a, 22b, 22c) zum Herstellen der das
Substrat (11) und den Halbleiterchip (13) verbindenden strukturierten Sinterschicht (12), welche sich innerhalb der Kontaktfläche (21) erstreckt und welche die Vielzahl von den zwischen dem Substrat (11) und dem Halbleiterchip (13) platzierten Sinterelementen (22a, 22b, 22c) umfasst,
wobei von jedem der Sinterelemente (22a, 22b, 22c) mindestens ein lateral zur Hauptoberfläche (11a) des Substrats (11) verlaufender Durchgangskanal (23) zwischen dem Substrat (11) und dem Halbleiterchip (13) zum Rand
der Kontaktfläche (21) besteht, wobei Prozessgase zu und von den Sinterelementen (22a, 22b, 22c) während des Sintervorgangs über die Durchgangskanäle (23) geführt werden, **dadurch gekennzeichnet, dass** die Flächenbelegungsdichte der Sinterelemente (22a) auf dem Substrat (11) in einem Mittelbereich (21a) der Kontaktfläche (21) größer ist als die Flächenbelegungsdichte der Sinterelemente (22c) in einem Randbereich (21c) der Kontaktfläche (21), und dadurch, dass die Sinterelemente (22a, 22b, 22c) laterale Einkerbungen (24) aufweisen, über die die Prozessgase während des Sintervorgangs zur Mitte der Sinterelemente (22a, 22b, 22c) zugeführt bzw. von selbigen abgeführt werden.

2. Verfahren nach Anspruch 1, wobei das Ausgangsmaterial eine Sinterpaste ist, wobei die Sinterpaste aus Mikro- und/oder Nanopartikeln besteht und wobei die Sinterpaste als Hauptbestandteil Silber enthält.

3. Verfahren nach einem der Ansprüche 1 und 2, wobei die Anzahl der Sinterelemente (22a, 22b, 22c) im Randbereich (21c) der Kontaktfläche (21) größer als die Anzahl der Sinterelemente (22a, 22b, 22c) im Mittelbereich (21a) der Kontaktfläche (21) ist.

4. Verfahren nach einem der Ansprüche 1 bis 3, wobei die Flächenbelegungsdichte der Sinterelemente (22a, 22b, 22c) auf dem Substrat (11) in einem Bereich (21b) der Kontaktfläche (21) zwischen dem Mittelbereich (21a) und dem Randbereich (21c) zwischen der Flächenbelegungsdichte in dem Randbereich (21c) und der Flächenbelegungsdichte in dem Mittelbereich (21a) der Kontaktfläche (21) liegt.

5. Verfahren nach einem der Ansprüche 1 bis 4, wobei der Rand der Kontaktfläche (21) in lateraler Richtung entlang der Hauptoberfläche (11a) des Substrats (11) von den Kanten des Halbleiterchips (13) um eine vorbestimmte Länge beabstandet ist.

6. Halbleiterbauelement (10), mit:
einem Substrat (11) mit einer Hauptoberfläche (11a);
einem Halbleiterchip (13), welcher auf der Hauptoberfläche (11a) des Substrats (11) angeordnet ist; und
einer strukturierten Sinterschicht (12), welche zwischen dem Substrat (11) und dem Halbleiterchip (13) auf einer Kontaktfläche (21) der Hauptoberfläche (11a) angeordnet ist, und welche den Halbleiterchip (13) mit dem Substrat (11) verbindet,
wobei die Sinterschicht (12) sich innerhalb der Kontaktfläche (21) erstreckt und eine Vielzahl von zwischen dem Substrat (11) und dem Halbleiterchip (13) platzierten Sinterelementen (22a, 22b, 22c) umfasst,
wobei von jedem der Sinterelemente (22a, 22b, 22c) mindestens ein lateral zur Hauptoberfläche (11a) des Substrats (11) verlaufender Durchgangskanal (23) zwischen dem Substrat (11) und dem Halbleiterchip (13) zum Rand der Kontaktfläche (21) besteht,
**dadurch gekennzeichnet, dass** die Flächenbelegungsdichte der Sinterelemente (22a) auf dem Substrat (11) in einem Mittelbereich (21a) der Kontaktfläche (21) größer ist als die Flächenbelegungsdichte der Sinterelemente (22c) in einem Randbereich (21c) der Kontaktfläche (21),
und dadurch, dass die Sinterelemente (22a, 22b, 22c) laterale Einkerbungen (24) aufweisen.

7. Halbleiterbauelement (10) nach Anspruch 6, wobei die Anzahl der Sinterelemente (22a, 22b, 22c) im Randbereich (21c) der Kontaktfläche (21) größer als die Anzahl der Sinterelemente (22a, 22b, 22c) im Mittelbereich (21a) der Kontaktfläche (21) ist.

8. Halbleiterbauelement (10) nach einem der Ansprüche 6 und 7, wobei die Flächenbelegungsdichte der Sinterelemente (22a, 22b, 22c) auf dem Substrat (11) in einem Bereich (21b) der Kontaktfläche (21) zwischen dem Mittelbereich (21a) und dem Randbereich (21c) zwischen der Flächenbelegungsdichte in dem Randbereich (21c) und der Flächenbelegungsdichte in dem Mittelbereich (21a) der Kontaktfläche (21) liegt.

9. Halbleiterbauelement (10) nach einem der Ansprüche 6 bis 8, wobei der Halbleiterchip (13) einen Leistungstransistor oder eine Leistungsdiode oder ein Thyristor und das Substrat (11) ein DBC-Substrat, IMS (Insulated Metal Substrate)-Substrat, PCB (Printed Circuit Board)-Substrat, AMB (Active Metal Brazing)-Substrat oder ein keramisches Ein- oder Mehrlagensubstrat umfasst.

10. Halbleiterbauelement (10) nach einem der Ansprüche 6 bis 9, wobei die laterale Ausdehnung der Sinterelemente (22a) im Mittelbereich (21a) der Kontaktfläche (21) größer als die laterale Ausdehnung der Sinterelemente (22c) im Randbereich (21c) der Kontaktfläche (21) ist.

## Claims

1. Method for producing a semiconductor component (10), comprising the following steps:
applying in a structured fashion a multiplicity of sintering elements (22a, 22b, 22c) composed of a starting material that forms a sintering layer (12) on a contact area (21) of a main surface (11a) of a substrate (11);
arranging a semiconductor chip (13) to be connected to the substrate (11) on the sintering elements (22a, 22b, 22c); and
heating and compressing the sintering elements (22a, 22b, 22c) in order to produce the structured sintering layer (12) which connects the substrate (11) and the semiconductor chip (13) and which extends within the contact area (21) and which comprises the multiplicity of sintering elements (22a, 22b, 22c) positioned between the substrate (11) and the semiconductor chip (13),
wherein from each of the sintering elements (22a, 22b, 22c) there is at least one passage channel (23) running laterally with respect to the main surface (11a) of the substrate (11) between the substrate (11) and the semiconductor chip (13) to the edge of the contact area (21), wherein process gases are guided to and from the sintering elements (22a, 22b, 22c) during the sintering process via the passage channels (23),
**characterized in that** the area occupation density of the sintering elements (22a) on the substrate (11) in a central region (21a) of the contact area (21) is greater than the area occupation density of the sintering elements (22c) in an edge region (21c) of the contact area (21), and **in that** the sintering elements (22a, 22b, 22c) have lateral notches (24), via which, during the sintering process, the process gases are fed to the centre of the sintering elements (22a, 22b, 22c) and are carried away from the same.

2. Method according to Claim 1, wherein the starting material is a sintering paste, wherein the sintering paste consists of micro- and/or nanoparticles and wherein the sintering paste contains silver as main constituent.

3. Method according to either of Claims 1 and 2, wherein the number of sintering elements (22a, 22b, 22c) in the edge region (21c) of the contact area (21) is greater than the number of sintering elements (22a, 22b, 22c) in the central region (21a) of the contact area (21).

4. Method according to any of Claims 1 to 3, wherein the area occupation density of the sintering elements (22a, 22b, 22c) on the substrate (11) in a region (21b) of the contact area (21) between the central region (21a) and the edge region (21c) is between the area occupation density in the edge region (21c) and the area occupation density in the central region (21a) of the contact area (21).

5. Method according to any of Claims 1 to 4, wherein the edge of the contact area (21) is spaced apart from the edges of the semiconductor chip (13) by a predetermined length in a lateral direction along the main surface (11a) of the substrate (11).

6. Semiconductor component (10), comprising:
a substrate (11) having a main surface (11a);
a semiconductor chip (13) arranged on the main surface (11a) of the substrate (11); and
a structured sintering layer (12) which is arranged between the substrate (11) and the semiconductor chip (13) on a contact area (21) of the main surface (11a) and which connects the semiconductor chip (13) to the substrate (11),
wherein the sintering layer (12) extends within the contact area (21) and comprises a multiplicity of sintering elements (22a, 22b, 22c) positioned between the substrate (11) and the semiconductor chip (13),
wherein from each of the sintering elements (22a, 22b, 22c) there is at least one passage channel (23) running laterally with respect to the main surface (11a) of the substrate (11) between the substrate (11) and the semiconductor chip (13) to the edge of the contact area (21),
**characterized in that** the area occupation density of the sintering elements (22a) on the substrate (11) in a central region (21a) of the contact area (21) is greater than the area occupation density of the sintering elements (22c) in an edge region (21c) of the contact area (21), and **in that** the sintering elements (22a, 22b, 22c) have lateral notches (24).

7. Semiconductor component (10) according to Claim 6, wherein the number of sintering elements (22a, 22b, 22c) in the edge region (21c) of the contact area (21) is greater than the number of sintering elements (22a, 22b, 22c) in the central region (21a) of the contact area (21).

8. Semiconductor component (10) according to either of Claims 6 and 7, wherein the area occupation density of the sintering elements (22a, 22b, 22c) on the substrate (11) in a region (21b) of the contact area (21) between the central region (21a) and the edge region (21c) is between the area occupation density in the edge region (21c) and the area occupation density in the central region (21a) of the contact area (21).

9. Semiconductor component (10) according to any of Claims 6 to 8, wherein the semiconductor chip (13) comprises a power transistor or a power diode or a thyristor and the substrate (11) comprises a DBC substrate, IMS (Insulated Metal Substrate) substrate, PCB (Printed Circuit Board) substrate, AMB (Active Metal Brazing) substrate or a ceramic single-layer or multilayer substrate.

10. Semiconductor component (10) according to any of Claims 6 to 9, wherein the lateral extent of the sintering elements (22a) in the central region (21a) of the contact area (21) is greater than the lateral extent of the sintering elements (22c) in the edge region (21c) of the contact area (21).

## Revendications

1. Procédé pour produire un composant semi-conducteur (10), comprenant les étapes consistant à :
déposer de manière structurée, sur une zone de contact (21) d'une surface principale (11a) d'un substrat (11), une pluralité d'éléments de frittage (22a, 22b, 22c) constitués d'un matériau de départ formant une couche de frittage (12) ;
disposer une puce semi-conductrice (13) à relier au substrat (11) sur les éléments de frittage (22a, 22b, 22c) ; et
chauffer et comprimer les éléments de frittage (22a, 22b, 22c) pour produire la couche de frittage (12) structurée reliant le substrat (11) et la puce semi-conductrice (13), qui s'étend à l'intérieur de la zone de contact (21) et qui comprend la pluralité des éléments de frittage (22a, 22b, 22c) placés entre le substrat (11) et la puce semi-conductrice (13),
dans lequel au moins un canal de passage (23) s'étendant latéralement à la surface principale (11a) du substrat (11) entre le substrat (11) et la puce semi-conductrice (13) depuis chacun des éléments de frittage (22a, 22b, 22c) existe jusqu'au bord de la surface de contact (21), dans lequel, pendant le processus de frittage, des gaz de traitement sont acheminés par le biais des canaux de passage (23) vers et depuis les éléments de frittage (22a, 22b, 22c),
**caractérisé en ce que** la densité surfacique d'occupation des éléments de frittage (22a) sur le substrat (11) est supérieure, dans une zone centrale (21a) de la surface de contact (21), à la densité surfacique d'occupation des éléments de frittage (22c) dans une zone de bord (21c) de la surface de contact (21),
et **en ce que** les éléments de frittage (22a, 22b, 22c) présentent des entailles latérales (24) par le biais desquelles, pendant le processus de frittage, les gaz de traitement sont acheminés vers le centre des éléments de frittage (22a, 22b, 22c) ou en sont évacués.

2. Procédé selon la revendication 1, dans lequel le matériau de départ est une pâte de frittage, dans lequel la pâte de frittage est constituée de microparticules et/ou de nanoparticules et dans lequel la pâte de frittage contient de l'argent comme constituant principal.

3. Procédé selon l'une des revendications 1 et 2, dans lequel le nombre des éléments de frittage (22a, 22b, 22c) dans la zone de bord (21c) de la surface de contact (21) est supérieur au nombre des éléments de frittage (22a, 22b, 22c) dans la zone centrale (21a) de la surface de contact (21).

4. Procédé selon l'une des revendications 1 à 3, dans lequel la densité surfacique d'occupation des éléments de frittage (22a, 22b, 22c) sur le substrat (11) dans une zone (21b) de la surface de contact (21) située entre la zone centrale (21a) et la zone de bord (21c) se situe entre la densité surfacique d'occupation dans la zone de bord (21c) et la densité surfacique d'occupation dans la zone centrale (21a) de la surface de contact (21).

5. Procédé selon l'une des revendications 1 à 4, dans lequel le bord de la surface de contact (21) est espacé des bords de la puce semi-conductrice (13) d'une longueur prédéterminée dans une direction latérale le long de la surface principale (11a) du substrat (11).

6. Composant semi-conducteur (10), comportant :
un substrat (11) ayant une surface principale (11a) ;
une puce semi-conductrice (13) disposée sur la surface principale (11a) du substrat (11) ; et
une couche de frittage (12) structurée qui est disposée entre le substrat (11) et la puce semi-conductrice (13) sur une surface de contact (21) de la surface principale (11a) et qui relie la puce semi-conductrice (13) au substrat (11),
dans lequel la couche de frittage (12) s'étend à l'intérieur de la surface de contact (21) et comprend une pluralité d'éléments de frittage (22a, 22b, 22c) placés entre le substrat (11) et la puce semi-conductrice (13), au moins un canal de passage (23) s'étendant latéralement à la surface principale (11a) du substrat (11) entre le substrat (11) et la puce semi-conductrice (13) depuis chacun des éléments de frittage (22a, 22b, 22c) existe jusqu'au bord de la surface de contact (21),
**caractérisé en ce que** la densité surfacique d'occupation des éléments de frittage (22a) sur le substrat (11) est supérieure, dans une zone centrale (21a) de la surface de contact (21), à la densité surfacique d'occupation des éléments de frittage (22c) dans une zone de bord (21c) de la surface de contact (21),
et **en ce que** les éléments de frittage (22a, 22b, 22c) présentent des entailles latérales (24).

7. Composant semi-conducteur (10) selon la revendication 6, dans lequel le nombre des éléments de frittage (22a, 22b, 22c) dans la zone de bord (21c) de la surface de contact (21) est supérieur au nombre des éléments de frittage (22a, 22b, 22c) dans la zone centrale (21a) de la surface de contact (21).

8. Composant semi-conducteur (10) selon l'une des revendications 6 et 7, dans lequel la densité surfacique d'occupation des éléments de frittage (22a, 22b, 22c) sur le substrat (11) dans une zone (21b) de la surface de contact (21) située entre la zone centrale (21a) et la zone de bord (21c) se situe entre la densité surfacique d'occupation dans la zone de bord (21c) et la densité surfacique d'occupation dans la zone centrale (21a) de la surface de contact (21).

9. Composant semi-conducteur (10) selon l'une des revendications 6 à 8, dans lequel la puce semi-conductrice (13) comprend un transistor de puissance ou une diode de puissance ou un thyristor et le substrat (11) comprend un substrat DBC, un substrat IMS (Insulated Metal Substrate), un substrat PCB (Printed Circuit Board), un substrat AMB (Active Metal Brazing) ou un substrat céramique à une ou plusieurs couches.

10. Composant semi-conducteur (10) selon l'une des revendications 6 à 9, dans lequel l'étendue latérale des éléments de frittage (22a) dans la zone centrale (21a) de la surface de contact (21) est supérieure à l'étendue latérale des éléments de frittage (22c) dans la zone de bord (21c) de la surface de contact (21).
